(19) Europäisches Patentamt
European Patent Office
Office européen des brevets

(11) **EP 3 007 963 B1**

(12) **EUROPÄISCHE PATENTSCHRIFT**

(45) Veröffentlichungstag und Bekanntmachung des Hinweises auf die Patenterteilung:
**21.12.2016 Patentblatt 2016/51**

(21) Anmeldenummer: **14730741.7**

(22) Anmeldetag: **30.05.2014**

(51) Int Cl.:
*B62L 3/00* (2006.01)      *G01R 19/155* (2006.01)
*G01R 31/00* (2006.01)     *B60L 3/04* (2006.01)
*B60L 11/18* (2006.01)     *G01R 31/02* (2006.01)
*B60L 1/00* (2006.01)      *B60L 1/02* (2006.01)

(86) Internationale Anmeldenummer:
**PCT/EP2014/001465**

(87) Internationale Veröffentlichungsnummer:
**WO 2014/198383 (18.12.2014 Gazette 2014/51)**

(54) **VERFAHREN ZUR ÜBERPRÜFUNG DER SPANNUNGSFREIHEIT EINER LEISTUNGSELEKTRONIKBAUEINHEIT EINES KRAFTFAHRZEUGS**

METHOD FOR CHECKING THE ABSENCE OF VOLTAGE ON A POWER ELECTRONIC COMPONENT OF A MOTOR VEHICLE

PROCÉDÉ PERMETTANT DE VÉRIFIER L'ABSENCE DE TENSION AU NIVEAU D'UNE UNITÉ ÉLECTRONIQUE DE PUISSANCE D'UN VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.06.2013 DE 102013009802**

(43) Veröffentlichungstag der Anmeldung:
**20.04.2016 Patentblatt 2016/16**

(73) Patentinhaber: **Audi AG**
**85045 Ingolstadt (DE)**

(72) Erfinder: **STAUDENMAIER, Sascha**
**85049 Ingolstadt (DE)**

(74) Vertreter: **Lehle, Josef**
**AUDI AG**
**Patentabteilung**
**85045 Ingolstadt (DE)**

(56) Entgegenhaltungen:
EP-A2- 2 556 980        DE-A1-102010 045 501
DE-A1-102010 056 235    DE-A1-102011 104 224
DE-A1-102011 104 819    US-A1- 2010 250 194

**Beschreibung**

Die Erfindung betrifft ein Verfahren zur Überprüfung der Spannungsfreiheit einer mit einer Hochspannungsbatterie und einer Elektromaschine verbundenen Leistungselektronikbaueinheit in einem Hochspannungsnetz eines Kraftfahrzeugs, das eine höhere Spannung als ein Niedrigspannungsnetz des Kraftfahrzeugs aufweist, wobei die Leistungselektronikbaueinheit einen Zwischenkreiskondensator, einen passiven Entladewiderstand, einen Steckanschluss für wenigstens einen Hochspannungsverbraucher und eine dem Steckanschluss vorgeschaltete Sicherung aufweist.

Es sind im Stand der Technik bereits Kraftfahrzeuge bekannt, die sowohl ein Niedrigspannungsnetz, dessen Spannung beispielsweise bei 12V liegt, wie auch ein Hochspannungsnetz, dessen Spannung höher liegt als die des Niedrigspannungsnetzes, aufweisen. Die bekanntesten Beispiele hierfür sind Hybridkraftfahrzeuge und Elektrokraftfahrzeuge. Diese weisen eine Elektromaschine auf, die sowohl den Vortrieb des Kraftfahrzeugs unterstützen kann wie auch elektrische Energie aus der Bewegung des Kraftfahrzeugs erzeugen kann. Ferner ist dem Hochspannungsnetz üblicherweise auch eine Hochspannungsbatterie zugeordnet. Als Hochspannungsnetze in engerem Sinne können alle Bordnetze eines Kraftfahrzeugs verstanden werden, deren Spannung größer als 60V Gleichspannung (DC) ist.

Ist ein derartiges Hochspannungsnetz ohnehin vorhanden, ist es üblich, in dem Kraftfahrzeug weitere Hochspannungsverbraucher vorzusehen. Beispiele hierfür sind neben einem für die Hochspannungsbatterie nutzbaren Ladegerät (oft auch als "On Board Charger" - OBC bezeichnet) einer Klimaanlage zugeordnete Vorrichtungen, beispielsweise ein Kompressor, oder Hochspannungs-Heizeinrichtungen.

Nachdem die Elektromaschine eine Wechselspannung erzeugt und auch anderweitig gegebenenfalls Spannungen abgeglichen werden müssen, ist in Hochspannungsnetzen der beschriebenen Art eine Leistungselektronikbaueinheit vorgesehen, an die die Elektromaschine und die Hochspannungsbatterie, üblicherweise fest, angeschlossen sind. Ferner weist eine derartige Leistungselektronikbaueinheit beispielsweise einen Steckanschluss auf, über den weitere Hochspannungsverbraucher mittels eines Steckers und einer geeigneten Kabelverbindung angeschlossen werden können. Die Leistungselektronikbaueinheit kann dabei neben einem Umrichter, der für die Umwandlung von Wechselspannung seitens der Elektromaschine in Gleichspannung seitens des restlichen Hochspannungsnetzes und umgekehrt vorgesehen ist, auch Gleichrichter als Komponenten aufweisen. Ferner enthält die Leistungselektronikbaueinheit üblicherweise einen Zwischenkreiskondensator, dem neben Komponenten zur aktiven Entladung auch ein passiver Entladewiderstand parallelgeschaltet sein kann. Eine üblicherweise zwischen der Parallelschaltung aus dem Zwischenkreiskondensator und dem Entladewiderstand und dem Steckanschluss vorgesehene Sicherung trennt die Hochspannungsverbraucher im Falle eines Kurzschlusses von der Hochspannungsversorgung ab.

Eine wichtige Thematik bei Kraftfahrzeugen, die ein derartiges Hochspannungsnetz aufweisen, ist der Schutz von Personen im Hinblick auf die Hochspannung. Insbesondere dann, wenn das Kraftfahrzeug gewartet werden soll, beispielsweise in einer Werkstatt, muss es auf möglichst einfache, aber sichere Weise möglich sein, den Schutz von Personen vor der Hochspannung herzustellen. Während Steckverbindungen, beispielsweise die des Steckanschlusses, häufig ohnehin berührschutzsicher ausgebildet sind, muss dennoch sichergestellt werden, dass nach einer Deaktivierung des Hochspannungsnetzes keine Hochspannungen mehr im System verbleiben. Dies gilt insbesondere für die Leistungselektronikbaueinheit, nachdem dort beispielsweise am Zwischenkreiskondensator noch Spannungen vorliegen könnten, wenn Fehler auftreten und/oder die Entlademechanismen versagen. Mithin sind bereits Vorgehensweisen bekannt, um die Spannungsfreiheit auch innerhalb der Leistungselektronikbaueinheit sicherzustellen.

So ist es im Stand der Technik bekannt, zunächst die Hochspannungsbatterie vom Hochspannungsnetz zu trennen. Dies geschieht üblicherweise über Schütze, die an oder in der Hochspannungsbatterie vorgesehen sind. Ferner ist üblicherweise ein sogenannter "Service Disconnect" vorgesehen, der die Betriebsspannung für die Schütze entfernt, wenn er gezogen wird, und zudem auch die Hochspannungs-Pilotlinie unterbricht. Um das Hochspannungsnetz gegen ein Wiedereinschalten zu sichern, wird dieser 12V-Service-Disconnect üblicherweise mit einem Schloss gesichert.

Um die Spannungsfreiheit an der Leistungselektronikbaueinheit festzustellen, ist es nun bekannt, die Leistungselektronikbaueinheit zu öffnen, beispielsweise, indem ein Deckel der Leistungselektronikbaueinheit geöffnet wird. Sodann wird mit einem Messgerät an vorbestimmten, speziellen Messstellen in der Leistungselektronikbaueinheit überprüft, ob noch eine Hochspannung vorliegt. Dies ist in vielerlei Hinsicht nachteilhaft. Zum einen erhöht das Öffnen der Leistungselektronikbaueinheit und das Vornehmen mehrerer Spannungsmessungen innerhalb der Leistungselektronikbaueinheit die Zeitdauer, die für die Freischaltung des Hochspannungsnetzes benötigt wird. Durch die Öffnung des Gehäuses der Leistungselektronikbaueinheit entsteht zudem nicht nur ein hohes Verschmutzungsrisiko, sondern auch die Dichtigkeit des Gehäuses der Leistungselektronikbaueinheit kann verringert werden. Die Vorgehensweise ist ferner kostenintensiv, da in der Leistungselektronikbaueinheit ein sogenannter Berührschutzeinleger notwendig ist. Auch für den Freischaltvorgang an sich liegt ein hoher Kostenbedarf vor, nachdem der Berührschutzeinleger und die Schrauben ausgetauscht werden müssen, nachdem die Leistungselektronikbaueinheit geöffnet wurde.

Es wurden auch bereits Anstrengungen unternommen, die Spannungsfreiheit im Hochspannungsnetz, speziell auch in der Leistungselektronikbaueinheit, eigendiagnosefähig im Kraftfahrzeug selbst zu ermitteln, jedoch ist hierzu noch keine die allgemeinen Sicherheitsanforderungen erfüllende und gängige Variante bekannt, so dass eine manuelle Freischaltung und dabei eine manuelle Überprüfung der Spannungsfreiheit weiterhin erforderlich und sinnvoll ist.

DE 10 2010 056 235 A1 betrifft ein Verfahren zum Testen einer Prüfeinrichtung zum Bestimmen eines Spannungszustandes eines Hochvoltbornetzes eines Kraftwagens. Es wird eine Prüfspannung zum Erzeugen eines vordefinierten Spannungszustandes gezielt, insbesondere durch eine externe Spannungsquelle, eingespeist und mit der Prüfeinrichtung vermessen. Der von der Prüfeinrichtung gemessene Spannungszustand wird mit dem vorgegebenen Spannungszustand verglichen, wobei bei einer Abweichung ein Fehler festgestellt wird.

DE 10 2010 012 154 A1 betrifft ein Verfahren zum Überprüfen eines Zustands eines Stromkreises eines Kraftfahrzeugs. Nach Anforderung eines Zustandes wird überprüft, ob dieser auch tatsächlich vorliegt. Konkret kann die Spannung des Stromkreises zur Überprüfung vermessen werden.

Die nachveröffentlichte DE 10 2012 000 598 A1 offenbart ein Kraftfahrzeughochvoltsystem mit einer Brennstoffzelleneinheit. Eine Sicherheitseinheit begrenzt zumindest bei inaktiver Antriebseinheit die Spannung im Hochvoltbordnetz und misst diese, um sie überwachen zu können.

Der Erfindung liegt daher die Aufgabe zugrunde, eine demgegenüber verbesserte, insbesondere vereinfachte und ein Öffnen der Leistungselektronikbaueinheit vermeidende Möglichkeit anzugeben, die Spannungsfreiheit der Leistungselektronikbaueinheit festzustellen.

Zur Lösung dieser Aufgabe ist bei einem Verfahren der eingangs genannten Art erfindungsgemäß vorgesehen, dass nach einer Trennung der Hochspannungsbatterie von dem Hochspannungsnetz und bei aus dem Steckanschluss oder einem Zielanschluss des in dem Steckanschluss eingesetzten Kabels gezogenen Stecker über den Hochspannungskontakten des Steckanschlusses eine Speisespannung angelegt und der Spannungsverlauf über die Hochspannungskontakte mit einem Messgerät und/oder nach einer definierten Aufladezeitspanne des Zwischenkreiskondensators der Widerstand über die Hochspannungskontakte mit dem Messgerät vermessen wird, wobei eine Spannungsfreiheit bei einem in einem ersten Sollbereich liegenden Spannungsverlauf bzw. einem in einem zweiten Sollbereich liegenden Widerstand festgestellt wird.

Der Erfindung liegt dabei die Erkenntnis zugrunde, dass ein einfaches Messen der an dem Steckanschluss über die Hochspannungskontakte anliegenden Spannung aufgrund der Sicherung nicht zum gewünschten Ergebnis führt. Zwar ist in dem weit überwiegenden Teil der Fälle die Sicherung nicht defekt, so dass die Spannungsfreiheit korrekt festgestellt werden kann, jedoch wird immer dann, wenn die Sicherung nicht in Ordnung ist (oder ein Kabelbruch oder dergleichen vorliegt) an dem Steckanschluss eine Hochspannungsfreiheit gemessen, die innerhalb der Leistungselektronikbaueinheit, insbesondere an dem Zwischenkreiskondensator, nicht zwangsläufig gegeben sein muss. Denn die Sicherung ist zwischen der Parallelschaltung aus Zwischenkreiskondensator und Entladewiderstand und dem Steckanschluss vorgesehen, so dass bei einer dort unterbrochenen Leitung innerhalb der Leistungselektronikbaueinheit, insbesondere aufgrund einer defekten Sicherung, nicht mehr korrekt gemessen werden könnte. Daher schlägt die vorliegende Erfindung eine Messvariante vor, die die Sicherung zusätzlich plausibilisiert. Hierzu ist vorgesehen, nachdem der Zwischenkreiskondensator vollständig aktiv oder auch passiv entladen sein sollte, was bevorzugt, wie später erläutert, durch eine weitere Messung überprüft wird, über den Steckanschluss eine Speisespannung (Schutzkleinspannung) anzulegen, die bevorzugt kleiner als 30V ist. Denkbare Werte sind für eine Messung des Spannungsverlaufs 24V, für eine Messung des Widerstandes, die erfindungsgemäß bevorzugt ist, 4V, wobei hier auch die ohnehin vom Widerstandsmessgerät erzeugte Messspannung als Speisespannung verwendet werden kann. Ist das Gesamtsystem, insbesondere also auch die Sicherung, intakt, wird sich nun zunächst der Zwischenkreiskondensator auf die Speisespannung bzw. bei einem zur Messung gebildeten Spannungsteiler auf eine entsprechende Teilspannung aufladen, woraufhin sämtlicher Stromfluss bzw. Spannungsabfall über den Entladewiderstand (und gegebenenfalls in der Messanordnung gezielt vorgesehene weitere Widerstände, worauf noch näher eingegangen werden wird) erfolgt.

Wird der Spannungsverlauf in einer ersten, weniger bevorzugten Variante der Erfindung betrachtet, bei der mithin zu wenigstens zwei Zeitpunkten gemessen werden muss, existieren je nach Zustand der Sicherung und vorhandener Spannungsfreiheit mehrere Optionen. Ist die Sicherung defekt, wird der Spannungsverlauf ein äußerst schnelles, insbesondere sprunghaftes, Ansteigen der Spannung auf den Wert der Speisespannung wiedergeben, da keinerlei Stromfluss innerhalb der Leistungselektronikbaueinheit mehr stattfinden kann. Ist die Sicherung in Ordnung und ist der Zwischenkreiskondensator hinreichend, beispielsweise auf 0,5V, entladen, wird der Zwischenkreiskondensator nun langsam wieder aufgeladen, was in einem langsam ansteigenden Spannungsverlauf resultiert, insbesondere, wenn eine Spannung von $U_L$ eingegeben wird, nach der Formel

$$U_M(t)=U_L*(1-e^{-(t/\tau)})$$

wobei UM die gemessene Spannung und $\tau$ die Zeitkonstante ist. Wenn die Sicherung funktionsfähig ist, aber noch eine größere Restspannung in der Leistungselektronikbaueinheit vorliegt, wird die ohnehin innerhalb der Leistungselektronikbaueinheit vorliegende Spannung gemessen.

Durch Überwachung des Spannungsverlaufs ist es also möglich, klar zu unterscheiden zwischen Fällen, in denen die Spannungsfreiheit gegeben ist und die Sicherung in Ordnung ist und allen Fehlerfällen, beispielsweise einer defekten Sicherung und einer nicht gegebenen Spannungsfreiheit. Hierzu wird der gemessene Spannungsverlauf mit einem ersten Sollbereich für den Spannungsverlauf verglichen, der beispielsweise aus Kalibrationsmessungen, Simulationen und/oder Berechnungen für die spezielle Konfiguration leicht hergeleitet werden kann. Nur dann, wenn der gemessene Spannungsverlauf innerhalb dieses ersten Sollbereichs liegt, ist davon auszugehen, dass sicher eine Spannungsfreiheit innerhalb der Leistungselektronikbaueinheit vorliegt. Dabei ist im Übrigen die Messung des Spannungsverlaufs auch als eine einfache Zweipunktmessung denkbar, indem zu bestimmten Zeitpunkten nach Anlegen der Speisespannung gemessen und mit entsprechenden ersten Sollbereichen verglichen wird. Möglich ist es auch, zur Auswertung ein Verzögerungsglied zu verwenden, welches nach einer bestimmten Zeitspanne, beispielsweise 0,5 s, überprüft, ob die gemessene Spannung kleiner als 20V ist. Selbstverständlich hat jedoch auch eine Beobachtung des gesamten Spannungsverlaufs Vorteile, nachdem beispielsweise im Sinne einer Diagnose auf bestimmte vorliegende Fehler, wie bereits beschrieben wurde, geschlossen werden kann, beispielsweise eine defekte Sicherung.

Die erfindungsgemäß bevorzugte Alternative ist jedoch eine Vermessung des Widerstandes. Wird der Widerstand während des Aufladevorgangs des Zwischenkreiskondensators bei Beaufschlagung mit der Speisespannung betrachtet, so wird dieser langsam ansteigen und bereits nach einer relativ kurzen Zeit, beispielsweise nach einer Wartezeit von wenigstens 5 Sekunden, beispielsweise 7 - 21 s, einen relativ festen, also nur noch sehr langsam ansteigenden Wert erreichen, der kennzeichnend für den korrekten Zustand und die Spannungsfreiheit der Leistungselektronikbaueinheit ist, also eine durch den zweiten Sollbereich definierte Schwelle mit Sicherheit überschritten hat. Ist nämlich der Widerstand unendlich hoch, spricht dies für eine defekte Sicherung oder einen Kabelbruch, entweder in der Leistungselektronikbaueinheit selbst oder andernorts in der Messkette. Die Spannungsfreiheit innerhalb der Leistungselektronikbaueinheit kann dann nicht sicher festgestellt werden. Wird keine Vorabmessung, wie sie später noch beschrieben wird, vorgenommen, die bei zu hoher festgestellter Spannung eine Widerstandsmessung ausschließen sollte, und liegt noch eine hohe Spannung innerhalb der Leistungselektronikbaueinheit vor und ist die Sicherung in Ordnung, so wird ersichtlich die Speisespannung praktisch "überschrieben" und es wird kein sinnvolles Messergebnis (voraussichtlich "Messfehler") erhalten. Es wird jedoch darauf hingewiesen, dass eine solche Messung der Spannung über die Hochspannungskontakte des Steckanschlusses bevorzugt wird, da dies die Sicherheit erhöht. Liegt ein Kurzschluss vor, wird ein sehr niedriger Widerstand bzw. ein anderweitig in die Messkette eingebrachter Widerstand gemessen, beispielsweise wenigstens ein Personenschutzwiderstand. Es existiert also ein eindeutig definierter zweiter Sollbereich für den Widerstand, in dem mit Sicherheit eine Spannungsfreiheit innerhalb der Leistungselektronikbaueinheit vorliegt. Auch hier kann der Sollbereich selbstverständlich über Kalibrierungsmessungen, Simulationen und/oder Berechnungen ermittelt werden.

Das Vornehmen einer Widerstandsmessung wird vor allem bevorzugt, da die zeitliche Komponente weniger wesentlich ist. Es muss lediglich eine bestimmte Zeit gewartet werden, bis die Widerstandsmessung vorgenommen wird, wann sie dann jedoch erfolgt, ist letztlich irrelevant. Zudem bietet die Widerstandsmessung den Vorteil, dass die Speisespannung als Messspannung meist ohnehin von dem entsprechenden Messgerät geliefert wird, um intern die geeigneten Bedingungen für die Strommessung und das Widerstandsergebnis herzustellen.

Nachdem die Messung des Spannungsverlaufs bzw. die Widerstandsmessung vorgenommen wurde, wird die Speisespannung wieder entfernt. Es kann vorgesehen sein, zur zusätzlichen Prüfung auch den Spannungsverlauf beim Entladen aufzunehmen und zu bewerten, was jedoch nicht zwangsläufig notwendig ist und insbesondere bei einer Widerstandsmessung auch entfallen kann.

Damit schlägt das erfindungsgemäße Verfahren insgesamt eine Lösung vor, in der ohne ein Öffnen der Leistungselektronikbaueinheit vorzunehmen eine Spannungsfreiheit innerhalb der Leistungselektronikbaueinheit von außerhalb der Leistungselektronikbaueinheit festgestellt werden kann, wobei zusätzlich noch der Status einer Sicherung überprüft wird, mithin als Fehlerquelle für eine trügerische Messung einer Spannungsfreiheit ausgeschlossen wird. Auf diese Weise kann ein Öffnen eines Gehäuses der Leistungselektronikbaueinheit, beispielsweise eines Deckels, entfallen. Das Verschmutzungsrisiko und das Dichtigkeitsrisiko für die Leistungselektronikbaueinheit ist stark vermindert. Es ergeben sich Kosteneinsparungsmöglichkeiten, nachdem ein Berührschutzeinleger in der Leistungselektronikbaueinheit nicht mehr benötigt wird und somit entfallen kann. Dichtungen und Schrauben sowie Berührschutzeinleger müssen nicht mehr ausgetauscht werden. Zudem bietet das Vorgehen aber auch eine starke Einsparung von Arbeitszeit, die durch das Öffnen der Leistungselektronikbaueinheit benötigt wurde, sodass beispielsweise mehr als zwanzig Minuten Arbeitszeit eingespart werden kann. Ist ein Hochspannungs-Interlock (HV-Interlock, auch Sicherheitspilotlinie) im Deckel der Leistungselektronikbaueinheit vorgesehen, tritt keine nennenswerte Abnutzung auf. Es wird darauf hingewiesen, dass dann, wenn eine defekte Sicherung in der Leistungselektronikbaueinheit festgestellt wurde, die Leistungselektronikbaueinheit ohnehin geöffnet werden müsste, wobei dann das Feststellen der Spannungsfreiheit in der Leistungselektronik noch erfolgen kann.

Das erfindungsgemäße Verfahren bietet mithin die Grundlage für eine verlässliche und einfach durchzuführende Feststellung der Spannungsfreiheit innerhalb der Leistungselektronikbaueinheit, die auch durch weniger qualifiziertes Personal durchgeführt werden kann. Solange die Messwerte im jeweiligen Sollbereich liegen, ist die Spannungsfreiheit gegeben und es kann mit weiteren Arbeiten fortgeschritten werden. Wird eine Messung vorgenommen, die außerhalb des entsprechenden Sollbereichs liegt, kann als Rückfallebene ein Experte für Hochspannungssysteme bzw. eine Elektrofachkraft herangezogen werden oder gar bereits durch detailliertere Auswertung der Messwerte eine erste Diagnose erfolgen.

Eine zweckmäßige Weiterbildung der vorliegenden Erfindung sieht vor, dass vor der Spannungsverlaufs- und/oder Widerstandsmessung eine Spannungsmessung über die Hochspannungskontakte des Steckanschlusses durchgeführt wird. Zumindest für den Fall, dass die Sicherung in Ordnung ist, kann so bereits durch eine einfachere Spannungsmessung festgestellt werden, ob noch eine Hochspannung innerhalb der Leistungselektronikbaueinheit vorliegt, so dass im Zweifelsfall die Spannungsverlaufs- und/oder Widerstandsmessung auch entfallen kann, da dann ohnehin bekannt ist, dass ein Fehler vorliegt.

Vorzugsweise kann nach der Spannungsverlaufs- und/oder Widerstandsmessung bei festgestellter Spannungsfreiheit bei wenigstens einem wieder angeschlossenen Hochspannungsverbraucher eine Spannungsmessung über die Hochspannungskontakte des Steckanschlusses durchgeführt werden. Nachdem dann bekannt sein dürfte, dass die Sicherung nicht defekt ist (und auch kein sonstiges Problem vorliegt) kann die Spannungsfreiheit anschließend für alle Hochspannungskomponenten nochmals festgestellt werden. Dies kann die Sicherheit weiter erhöhen, doch ist dies weniger relevant, wenn die Hochspannungsverbraucher bzw. sonstigen Komponenten mit berührgeschützten Steckern ausgeführt sind. Weitere Fehlerfälle können optional abgedeckt werden, wenn zusätzlich eine Spannungsmessung zwischen jeweils einem Hochspannungskontakt des Steckanschlusses und einem Schirmkontakt zu einem Referenzpotential, insbesondere Masse, durchgeführt wird. Auf diese Weise können beispielsweise Kurzschlüsse zwischen Referenzpotential und einer Hochspannungsleitung festgestellt werden und dergleichen.

In diesem Zusammenhang sei noch angemerkt, dass als Hochspannungsverbraucher beispielsweise ein Ladegerät (OBC), ein Kompressor einer Klimaanlage, eine Hochspannungs-Heizeinrichtung und/oder dergleichen vorgesehen sein können. Beispielsweise ist es denkbar, dass Hochspannungsverbraucher über die Ladeeinrichtung an die Leistungselektronikbaueinheit angekoppelt werden, wobei jedoch auch andere Infrastrukturen möglich sind.

Insgesamt ist es bei der Vornahme von Spannungsmessungen sinnvoll, wenn bei jeder Spannungsmessung zunächst die Funktionsfähigkeit des Messgeräts durch Vermessung einer Referenzspannung überprüft wird, insbesondere der Spannung einer Niedrigspannungsbatterie des Niedrigspannungsnetzes. Beispielsweise kann also überprüft werden, ob das Messgerät für die Niedrigspannungsbatterie korrekt 12V anzeigt, bevor weitere Messungen vorgenommen werden. Auf diese Weise wird die Funktionsfähigkeit des Messgeräts und der Messleitungen überprüft und weitgehend sichergestellt.

In einer besonders vorteilhaften Ausgestaltung der vorliegenden Erfindung kann vorgesehen sein, dass nach Ziehen des Steckers zu dem wenigstens einen Hochspannungsverbraucher aus dem Steckanschluss oder Zielanschluss ein Messadapter an den Steckanschluss oder den aus dem Zielanschluss entnommenen Stecker des im Steckanschluss angesteckten Kabels angeschlossen wird, wobei das Messgerät und die Speisespannung an Messanschlüsse des Messadapters angeschlossen werden. Auf diese Weise muss das Messgerät nicht unmittelbar an dem nur bedingt geeigneten Steckanschluss betrieben werden, wo es unter Umständen aufgrund der berührgeschützten Steckverbindung Schwierigkeiten geben kann, eine korrekte Verbindung zu den Hochspannungskontakten herzustellen. Außerdem können durch die nicht bestimmungsgemäße Kontaktierung die Steckkontakte beschädigt/verkratzt werden, was zu höheren Übergangswiderständen im späteren Betrieb und im schlimmsten Fall zu Ausfällen führen könnte. Mithin ist ein solcher Messadapter äußerst vorteilhaft, nachdem er einen geeigneten Stecker aufweist, der in den Steckanschluss eingesteckt werden kann, bzw. einen geeigneten Steckanschluss aufweist, in den der Stecker eines in den Steckanschluss eingesteckten Kabels angeschlossen werden kann. Besonders bevorzugt ist beides vorgesehen, so dass die Hochspannungsverbraucher auch über den Messadapter wieder an die Leistungselektronikbaueinheit angeschlossen werden können, beispielsweise dann, wenn über weitere Spannungsmessungen das gesamte Hochspannungsnetz inklusive der Hochspannungsverbraucher überprüft werden soll. Ein solcher Messadapter weist dann geeignete Messanschlüsse auf, die speziell zum Anschluss von Messgeräten geeignet sind. Ein solcher Messadapter kann auch die Verbindung zu einem Referenzpotential, mithin einen Schirmkontakt, zur Verfügung stellen, wenn diesbezüglich Messungen vorgenommen werden sollen, oder aber auch eine Möglichkeit bieten, die Hochspannungs-Pilotlinie (Hochvolt-Interlock) zu überbrücken und dergleichen. In jedem Fall wird so eine verlässlichere Möglichkeit zum Anschluss des Messgerätes geboten, welches bevorzugt zumindest im Falle einer Widerstandsmessung auch die Speisespannung liefert.

In besonders zweckmäßiger Ausgestaltung der vorliegenden Erfindung kann der Messadapter für jeden Hochspannungs-Messanschluss einen Berührschutzwiderstand aufweisen, der bei der Ermittlung des ersten und/oder zweiten Sollbereichs insbesondere für den Widerstand berücksichtigt wird. Nicht nur wird damit eine weitere, bislang nicht geforderte Sicherheit geschaffen, die Berührschutzwiderstände erweisen sich auch als besonders vorteilhaft, wenn eine Widerstandsmessung durchgeführt wird. Denn dann bildet die Summe der Berührschutzwiderstände letztlich eine Art "Offset" für den Widerstand, der es insbesondere erlaubt, das Messgerät in einem einzigen, festen Messbereich zu betreiben, so dass Effekte durch das Umschalten von Messbereichen nicht mehr stark Einfluss auf die Messung nehmen können. Beispielsweise kann im Kiloohm-Bereich gemessen werden, wenn Berührschutzwiderstände von 100 kΩ jeweils eingesetzt werden. Die Berührschutzwiderstände erlauben es im Übrigen auch, zu unterscheiden, ob ein Kurzschluss vor oder nach den Berührschutzwiderständen vorliegt. Letztlich ist durch die Berührschutzwiderstände also eine Art Grundwert gegeben, zu dem noch im Normalfall, also bei Spannungsfreiheit und sonst intakten Komponenten, der Passiventladungswiderstand kommt, der in einem bestimmten Bereich liegt, nachdem auch weitere Widerstände Einfluss zusätzlich zu dem passiven Entladewiderstand in der Leistungselektronikbaueinheit nehmen, beispielsweise Widerstände innerhalb der Hochspannungsbatterie und dergleichen.

Es sei an dieser Stelle noch angemerkt, dass aufgrund des erfindungsgemäßen Vorgehens, also des Messens durch den Messadapter, selbstverständlich auch dieser in seiner Funktionsfähigkeit und Fehlerfreiheit überprüft wird. Denn bei Kurzschlüssen im Messadapter oder Leitungsbrüchen im Messadapter treten auch die bereits beschriebenen Effekte auf, die feststellbar sind. Hierdurch entfällt das ansonsten ggf. vorgeschriebene Überprüfen des Messadapters, mithin auch die weitere Belastung von Steckkontakten (beispielsweise Beschädigungen/Verkratzungen).

In bevorzugter Ausgestaltung kann die Auswertung des Spannungsverlaufs und/oder des Widerstands durch eine dem Messgerät nachgeschaltete Auswerteeinrichtung erfolgen. Das bedeutet, es ist auch denkbar, eine vollautomatische Analyse der Messwerte vorzunehmen, die entweder in der binären Entscheidung zwischen "Spannungsfreiheit gegeben" und "Spannungsfreiheit nicht gegeben oder Fehler" resultieren kann oder aber auch detaillierter erfolgen kann, beispielsweise im Hinblick auf bestimmte Fehler. So können beispielsweise auch Vergleichsspannungsverläufe bzw. Vergleichswiderstände bzw. -bereiche hinterlegt werden, die für bestimmte Fehlerfälle, beispielsweise eine defekte Sicherung, oder noch vorliegende Hochspannungen kennzeichnend sind, so dass eine computerisierte Auswertung auch Detailinformationen als Ergebnis der Messung liefern kann.

Zweckmäßigerweise sind das Messgerät und/oder die Auswerteeinrichtung Teil eines Werkstatt-Testers. Derartige Prüfeinrichtungen sind im Stand der Technik bereits bekannt und bieten meist auch Funktionen eines Multi-Messgerätes, so dass sowohl eine Spannungsmessung wie auch eine Widerstandsmessung mit derartigen Werkstatt-Testern möglich sein kann. Denkbar ist es beispielsweise auch, ein dediziertes, selbstständiges Messgerät vorzusehen, welches dann über eine geeignete Verbindung, beispielsweise eine USB-Verbindung, an den Werkstatt-Tester bzw. allgemein die Auswerteeinrichtung angekoppelt werden kann, so dass dort die automatisierte Auswertung erfolgen kann.

Wie bereits dargelegt wurde, können der erste und/oder zweite Sollbereich aus Ergebnissen einer Kalibrierungsmessung und/oder aus einer Simulation und/oder aus theoretischen Berechnungen ermittelt werden. Die Sollbereiche hängen dabei selbstverständlich von der konkreten Ausgestaltung des Hochspannungsnetzes und der Leistungselektronikbaueinheit ab, wobei zusätzlich verwendete Geräte Eingang finden, z. B. Messadapter oder die Messgeräte selbst.

Zweckmäßig ist es, wenn als der erste und/oder zweite Sollbereich für wenigstens zwei unterschiedliche Spezifikationen aufweisende Kraftfahrzeuge gültige Sollbereiche verwendet werden. Insbesondere ist es dann möglich, die gesamten Kraftfahrzeuge einer Flotte eines Herstellers abzudecken, wenn eine ausreichende Abgrenzung zu den Fehlerfällen möglich bleibt. In diesem Zusammenhang ist es auch sinnvoll, wenn ein standardisierter Messadapter und/oder ein standardisiertes Messgerät verwendet werden.

Wie bereits dargelegt wurde, kann bei einer Widerstandsmessung als Speisespannung die ohnehin von dem Messgerät verwendete Messspannung eingesetzt werden. Für die Spannungsverlaufsmessung ist es zweckmäßig, wenn ein Netzteil für die Speisespannung verwendet wird. Beispielsweise ist der Einsatz eines 24V-Netzteils möglich. Zum Schutz des Netzteils kann vorgesehen sein, eine Schutzdiode zu verwenden. Denkbar ist es beispielsweise, eine Schutz/Freilaufdiode mit einer Durchbruchspannung von 1000V einzusetzen. Auch kann es zweckmäßig sein, insbesondere, wenn keine Berührschutzwiderstände eingesetzt werden, in der Gesamtschaltung einen Ladewiderstand, beispielsweise mit einem Wert von 10 kΩ, zu verwenden. Das Netzteil, die Schutzdiode und gegebenenfalls der definierte Ladewiderstand können Teil eines Zusatzadapters sein, der wiederum auf einen Messadapter aufsetzbar ist. Dieser Zusatzadapter kann bereits geeignete Messanschlüsse aufweisen, die den Anschluss des Messgeräts zur Messung des Spannungsverlaufs ermöglichen.

Es sei an dieser Stelle noch angemerkt, dass eine Weiterbildung des erfindungsgemäßen Verfahrens auch vorsehen kann, dass bei einer Widerstandsmessung zusätzlich eine Messung des Widerstands zwischen dem Schirmkontakt eines Messadapters und dem Referenzpotential, insbesondere der Masse, des Kraftfahrzeugs vorgenommen werden kann. Auf diese Weise können weitere Fehlerfälle ausgeschlossen werden, insbesondere im Hinblick darauf, dass im Folgenden gegebenenfalls Spannungsmessungen zwischen den Hochspannungskontakten und dem Schirmkontakt vorgenommen werden können.

Zur Überprüfung der Spannungsfreiheit der Leistungselektronikbaueinheit gemäß dem erfindungsgemäßen Verfahren kann ein Prüfsystem vorgesehen werden, das einen direkt oder indirekt an den Steckanschluss der Leistungselektronikbaueinheit anschließbaren Messadapter, ein Messgerät und eine Auswerteeinrichtung umfassen kann. Die Auswerteeinrichtung ist dabei dazu ausgebildet, die gemessenen Spannungsverläufe und/oder Widerstände mit den entsprechenden Sollbereichen zu vergleichen und wenigstens im Hinblick auf eine sicher gegebene Spannungsfreiheit zu bewerten. Es können jedoch auch detailliertere Auswerteaufgaben durch die Auswerteeinrichtung erfüllt werden. Das Messgerät und/oder zumindest die Auswerteeinrichtung können dabei Teil eines Werkstatt-Testers sein.

Es sei an dieser Stelle noch angemerkt, dass der Messadapter, wie bereits beschrieben wurde, an den Steckanschluss der Leistungselektronikbaueinheit anschließbar ist, mithin einen geeignet standardisierten Stecker diesbezüglich aufweist. Bevorzugt ist es jedoch auch, wenn der Messadapter an ein in den Steckanschluss eingestecktes Kabel angeschlossen werden kann, mithin auch dementsprechend einen geeigneten, ebenso bevorzugt standardisieren Steckanschluss aufweist. In jedem Fall sollten die Stecksysteme, die bei der vorliegenden Erfindung eingesetzt werden, berührgeschützt ausgeführt sein, wobei eine Unterteilung in verschiedene Standards bzw. Klassen anhand der Stromtragfähigkeit möglich ist. Ist der Messadapter sowohl an einem Kabel als auch direkt an dem Steckanschluss der Leistungselektronikbaueinheit anschließbar, ist zudem der weitere Vorteil gegeben, dass letztlich abwechselnd ein Anschluss über das Kabel oder direkt an der Leistungselektronikbaueinheit erfolgen kann, so dass die empfindlichen Steckverbindungen geschont werden.

Weitere Vorteile und Einzelheiten der vorliegenden Erfindung ergeben sich aus den in Folgenden beschriebenen Ausführungsbeispielen sowie anhand der Zeichnung. Dabei zeigen:

Fig. 1 ein Hochspannungsnetz eines Kraftfahrzeugs im Betriebszustand,

Fig. 2 ein Zustand des Hochspannungsnetzes gemäß Fig. 1 in einer ersten Variante des erfindungsgemäßen Verfahrens,

Fig. 3 ein Zustand des Hochspannungsnetzes gemäß Fig. 1 bei einer zweiten Variante des erfindungsgemäßen Verfahrens,

Fig. 4 eine Prinzipskizze zur Messung eines Spannungsverlaufs,

Fig. 5 mögliche Spannungsverläufe mit einem ersten Sollbereich,

Fig. 6 eine Prinzipskizze zur Widerstandsmessung,

Fig. 7 ein möglicher Widerstandsverlauf mit einem zweiten Sollbereich, und

Fig. 8 der Zustand des Hochspannungsnetzes gemäß Fig. 1 zu einem späteren Zeitpunkt bei der ersten Variante des erfindungsgemäßen Verfahrens.

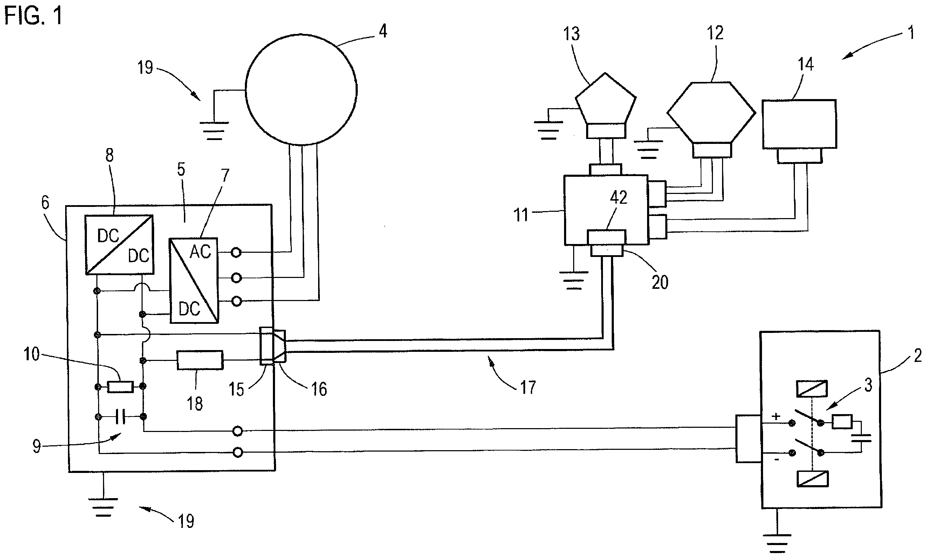

Fig. 1 zeigt in Form einer Prinzipskizze ein Hochspannungsnetz 1 eines Kraftfahrzeugs im Betriebszustand. Dieses wird über eine Hochspannungsbatterie 2 gespeist, die über Schütze 3 vom Hochspannungsnetz 1 abgetrennt werden kann. Ferner ist eine Elektromaschine 4 vorgesehen, die zum Antrieb des Kraftfahrzeugs beitragen kann oder aus dessen Bewegung elektrische Energie herleiten kann. Die Elektromaschine 4 arbeitet mit einer Wechselspannung, so dass eine Umrichtung erforderlich ist. Diese erfolgt in einer Leistungselektronikbaueinheit 5, an die sowohl die Elektromaschine 4 als auch die Hochspannungsbatterie 2 angeschlossen sind. Die Leistungselektronikbaueinheit 5 enthält vorliegend in einem Gehäuse 6 einen Umrichter 7, einen Gleichrichter 8, einen Zwischenkreiskondensator 9 und einen passiven Entladewiderstand 10. Dieser ist dem Zwischenkreiskondensator 9 parallelgeschaltet. Schlägt eine aktive Entladung des Zwischenkreiskondensators 9 fehl, kann die Entladung passiv über den Entladewiderstand 10 erfolgen.

In dem Hochspannungsnetz 1 sollen auch weitere Hochspannungsverbraucher betrieben werden, vorwiegend ein Ladegerät 11 mit zugehöriger Ladedose 12, ein Kompressor 13 für eine Klimaanlage des Kraftfahrzeugs und eine Hochspannungs-Heizeinrichtung 14. Um diese Komponenten mit elektrischer Energie versorgen zu können, weist die Leistungselektronikbaueinheit 5 einen Steckanschluss 15 auf, der berührgeschützt ist, und in den ein ebenso berührgeschützter Stecker 16 eingesteckt werden kann, der einem Kabel 17 zugehörig ist, das die Hochspannungsverbraucher 11, 13 und 14 versorgt. Vorwiegend sind der Kompressor 13 und die Heizeinrichtung 14 über die Ladeeinrichtung 11 angekoppelt, es sind jedoch auch andere Infrastrukturen denkbar.

Um bei einem Kurzschluss eine schnelle Trennung der Hochspannungsverbraucher von der Hochspannungsversorgung zu ermöglichen, ist zwischen der Parallelschaltung von Zwischenkreiskondensator 9 und Entladewiderstand 10 und dem Steckanschluss 15 eine Sicherung 18 angeordnet. Alle Komponenten weisen eine Verbindung zu einem Referenzpotential (Masse) 19 auf.

Sollen Arbeiten an dem Kraftfahrzeug 1, insbesondere konkret dem Hochspannungsnetz 1, vorgenommen werden, muss sichergestellt sein, dass keine Person in Kontakt mit einer Hochspannung kommt. Das Hochspannungsnetz 1 muss also vollständig ausgeschaltet und entladen werden ("freigeschaltet"). Dabei muss insbesondere sichergestellt werden, dass innerhalb der Leistungselektronikbaueinheit 5 keine restlichen Hochspannungen verbleiben, wozu es denkbar wäre, einen Deckel des Gehäuses 6 zu öffnen und an verschiedenen Punkten innerhalb der Leistungselektronikbaueinheit 5 Spannungen zu messen. Dies wird unter Verwendung des erfindungsgemäßen Verfahrens jedoch vermieden, welches im Folgenden näher erläutert werden soll.

Zum allgemeinen Freischalten des Hochspannungsnetzes 1 sind zunächst verschiedene Schritte zur Außerbetriebnahme durchzuführen. Zuerst ist selbstverständlich sicherzustellen, dass keine externen Spannungsquellen, beispielsweise Ladekabel, mit dem Kraftfahrzeug verbunden sind. Sodann muss das Hochspannungssystem deaktiviert werden, was konkret bedeutet, dass die Zündung (Klemme 15) ausgeschaltet werden muss und die Schütze 3 der Hochspannungsbatterie 2 dadurch geöffnet werden (Abschaltung der Klemme 31 beider Schütze). Sodann ist bei diesem Ausführungsbeispiel der 12V-Service-Disconnect, welcher beispielsweise im Motorraum angeordnet sein kann, zu betätigen, insbesondere herauszuziehen. Dieser unterstricht die Hochspannungs-Pilotlinie (Hochvolt-Interlock) und unterbricht die Stromversorgung (Klemme 30c) zu den Schützen 3 zusätzlich bzw. redundant. Um ein Wiederaktivieren zu vermeiden, kann der Service-Disconnect mit einem Vorhängeschloss gesichert werden. Auch die elektrische Energiezufuhr zu einem Niedrigspannungsnetz, dessen Spannung niedriger als die des Hochspannungsnetzes 1 ist, kann unterbrochen werden.

Nun soll sichergestellt werden, dass in der Leistungselektronikbaueinheit 5, insbesondere also auf dem Zwischenkreiskondensator 9, keine Hochspannung verblieben ist, die Leistungselektronikbaueinheit 5 also spannungsfrei geschaltet ist. Hierzu ist im erfindungsgemäßen Verfahren nun vorgesehen, zunächst die Hochspannungsverbraucher, also das Ladegerät 11, den Kompressor 13 und die Heizeinrichtung 14, von der Leistungselektronikbaueinheit 5 zu trennen. Hierzu bestehen ersichtlich zwei unterschiedliche Möglichkeiten, die beide verwendet werden können. Zum einen kann der Stecker 16 des Kabels 17 an der Leistungselektronikbaueinheit 5 gezogen werden, zum anderen jedoch auch der Stecker 20 des Kabels 17 an dem Zielanschluss 42 des Ladegeräts 11.

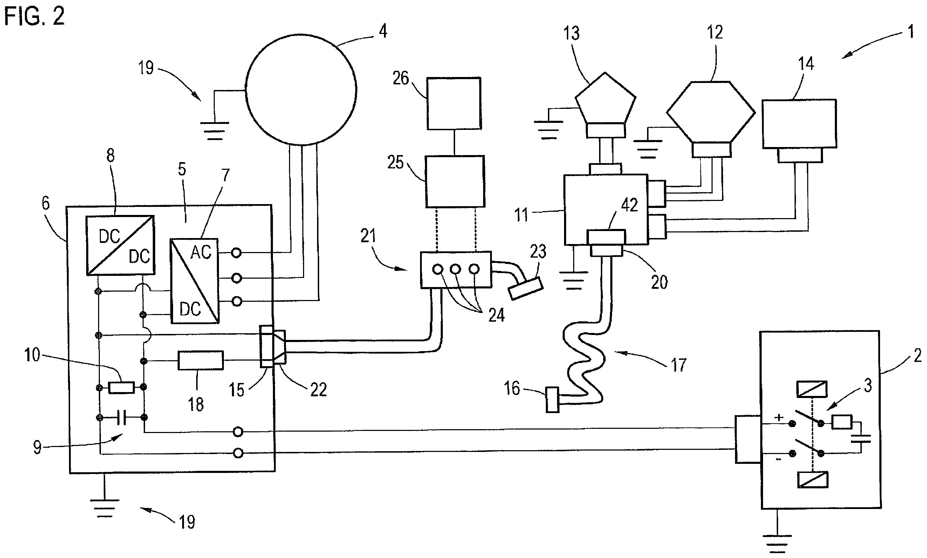

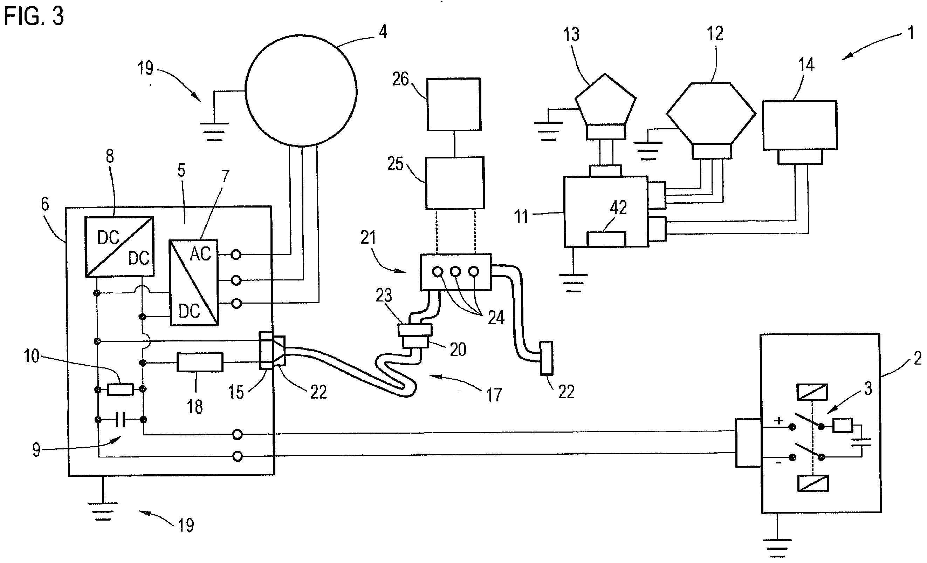

Diese beiden Varianten des erfindungsgemäßen Verfahrens sind jeweils in den Fig. 2 und 3 dargestellt. Beide Figuren können bei der weiteren Diskussion parallel betrachtet werden, nachdem der letztlich einzige Unterschied die Zwischenschaltung bzw. Nichtzwischenschaltung des Kabels 17 ist. Nun wird zunächst an die Leistungselektronikbaueinheit 5 ein Messadapter 21 angeschlossen. Im Fall der Fig. 2 geschieht dies unmittelbar am Steckanschluss 15 über einem dem Standard des Steckers 16 entsprechenden Stecker 22. Im Fall der Fig. 3 wird der Stecker 20 des Kabels 17 in einen Steckanschluss 23 des Messadapters 21 eingesteckt. Der Messadapter 21 weist Messanschlüsse 24 auf, die sich ideal zum Anschließen eines Messeräts 25 eignen, dem vorliegend eine Auswerteeinrichtung 26 nachgeschaltet ist. Über das Messgerät 25 können nun verschiedene Messungen durchgeführt werden, vornehmlich über die Hochspannungskontakte des Steckanschlusses 15, vorteilhafterweise ohne dass ein Öffnen der Leistungselektronikbaueinheit 5 erforderlich wäre.

Ein erster, optionaler Messabschnitt betrifft eine erste Vorabmessung zur Spannungsfreiheit der Leistungselektronikbaueinheit 5. In diesem ersten Messabschnitt wird zunächst das Messgerät 25 durch Vermessung einer Referenzspannung überprüft, hier durch Vermessung der Spannung einer Niedrigspannungsbatterie des Niedrigspannungsnetzes des Kraftfahrzeugs, das bedeutet, die Referenzspannung beträgt 12V. Ist auf diese Weise das korrekte Funktionieren des Messgeräts 25 überprüft, wird eine Messung der über die Hochspannungskontakte des Steckanschlusses 15 vorliegenden Spannung vorgenommen. Ist die Sicherung 18 nicht defekt und sind alle sonstigen Komponenten auf dem Messweg in Ordnung, würde dieses Messergebnis anzeigen, ob noch eine Hochspannung innerhalb der Leistungselektronikbaueinheit 5 verblieben ist. Liegt jedoch ein Kabelbruch vor oder ist die Sicherung 18 defekt, wäre diese Messung nicht verlässlich, das bedeutet, die Spannungsfreiheit ist nicht sicher.

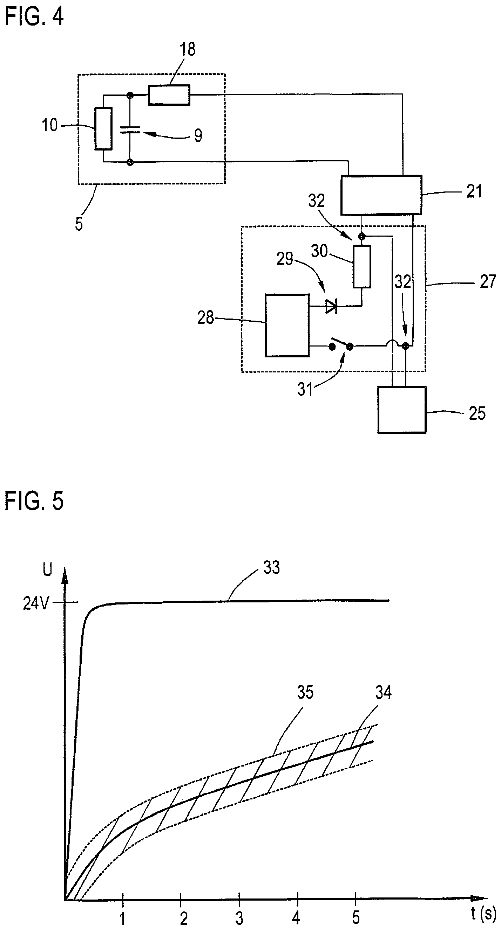

Daher folglich nun ein zweiter Messabschnitt, in dem in einem ersten Ausführungsbeispiel der vorliegenden Erfindung ein Spannungsverlauf nach Anlegen einer Speisespannung an den Hochspannungskontakten des Steckanschlusses 15 vermessen wird, in dem bevorzugteren zweiten Ausführungsbeispiel wird jedoch eine Widerstandsmessung nach Anlegen einer Speisespannung durchgeführt, was anhand der Fig. 4 - 7 nun näher erläutert werden soll.

Zunächst sei jedoch noch angemerkt, dass bereits vor Beginn des ersten Messabschnitts üblicherweise eine bestimmte Zeit abgewartet wird, um die aktive bzw. passive Entladung in der Leistungselektronikbaueinheit 5 sicherzustellen. Bei der aktiven Entladung kann beispielsweise nach 150 Sekunden im Normalfall eine Restspannung kleiner als 0,5 V erreicht sein, bei der passiven Entladung im Fehlerfall dauert dies beispielsweise 360 s, wobei selbstverständlich diese Werte von der konkreten Ausgestaltung abhängen. Sollte die aktive Entladung fehlschlagen und wird im ersten Messabschnitt nach der entsprechenden Wartezeit festgestellt, dass die Spannung dennoch sinkt, kann abgewartet werden, ob die passive Entladung Erfolg hat.

Fig. 4 zeigt nun vereinfacht die Verschaltung im Fall der Messung eines Spannungsverlaufs. Dabei sind nur die wesentlichen Komponenten der Leistungselektronikbaueinheit 5 gezeigt, nämlich der Zwischenkreiskondensator 9, der Entladewiderstand 10 und die Sicherung 18. Auf den Messadapter 21 ist nun ein Zusatzadapter 27 aufgesetzt, der ein Netzteil 28 enthält, das die Speisespannung, hier 24V, zur Verfügung stellt. Zum Schutz des Netzteils 28 enthält der Zusatzadapter 27 auch eine Schutzdiode 29 mit einer Durchbruchspannung von 1000V. Ferner ist ein Ladewiderstand 30 vorgesehen. Über einen Schalter 31 kann die Speisespannung gezielt zugeschaltet werden. Die Messung des Spannungsverlaufs durch das Messgerät 25 erfolgt an Abgriffspunkten 32.

Ist die Sicherung 18 defekt, wird als Messergebnis ein äußerst schneller, insbesondere sprunghafter Anstieg der Spannung, die gemessen wird, auf die Speisespannung erwartet, sobald diese angelegt wird, mithin der Schalter 31 geschlossen wird. Dies ist in Fig. 5, die die gemessene Spannung gegen die Zeit zeigt, anhand der Kurve 33 dargestellt. Ein ähnliches Verhalten wird erwartet, wenn beispielsweise ein Kabelbruch vorliegt. Ist jedoch das Gesamtsystem, insbesondere auch die Sicherung 18, in Ordnung, wird nun langsam der Kondensator 9 aufgeladen, so dass sich beispielsweise ein Verlauf wie in der Kurve 34 dargestellt ergibt. Ist dieser Verlauf gegeben, kann sicher eine Spannungsfreiheit der Leistungselektronikbaueinheit 5 angenommen werden. Nachdem es bei den Messungen zu Schwankungen kommen kann, sind durch Kalibrierungsmessungen, Simulationen und/oder Berechnungen die Grenzen dieses Bereichs, der die korrekte Spannungsfreiheit anzeigt, ermittelt worden, so dass sich ein erster Sollbereich 35 ergibt, in dem der gemessene Spannungsverlauf liegen sollte. Die Auswerteeinrichtung 26 überprüft dies im vorliegenden Ausführungsbeispiel automatisch und gibt einen entsprechenden Hinweis aus, ob die Spannungsfreiheit sicher gegeben ist oder ob sie nicht vorliegt bzw. ein sonstiger Fehler gegeben ist. Selbstverständlich kann der Spannungsverlauf auf Wunsch auch genauer ausgewertet werden, beispielsweise dahingehend, welcher Fehler vorliegen könnte. Beispielsweise deutet ein Spannungsverlauf wie in Kurve 33 an, dass die Sicherung 18 defekt ist oder ein Kabel- bzw. Leitungsbruch vorliegt. Bei einem Kurzschluss würde eine Spannung von 0V festgestellt. Möglich ist es aber auch, die Messung weitgehend zu vereinfachen, indem beispielsweise ein Verzögerungsglied verwendet wird, welches nur überprüft, ob die Spannung nach einer vorbestimmten Zeit, beispielsweise 0,5 s, noch kleiner als ein bestimmter Grenzwert, beispielsweise 20V, ist.

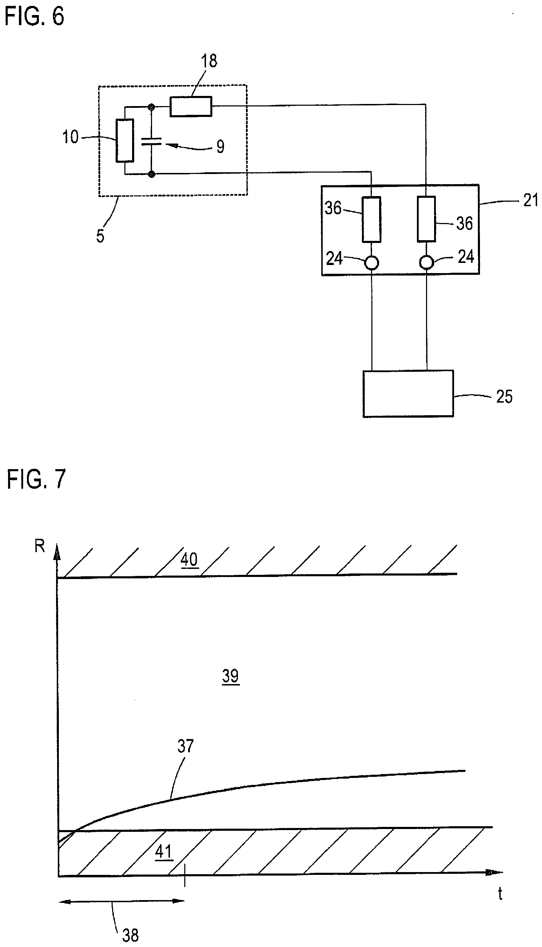

Eine einfachere Ausführungsform, die erfindungsgemäß bevorzugt ist, ergibt sich bei Vornahme einer Widerstandsmessung, die durch die Fig. 6 und 7 näher erläutert werden soll.

Auch in Fig. 6 sind nur die für die Messung wesentlichen Komponenten der Leistungselektronikbaueinheit 5 gezeigt, nämlich der Entladewiderstand 10, der Zwischenkreiskondensator 9 und die Sicherung 18. Zumindest in diesem Fall sind innerhalb des Messadapters 21, den Messanschlüssen 24 vorgeschaltet, Berührschutzwiderstände 36 vorgesehen, vorliegend mit einem Wert von 100 kΩ. Diese erhöhen nicht nur die Sicherheit des Messadapters 21 im mehrfachen Fehlerfall, sondern bieten zudem eine Art Grundwert für die Widerstandsmessung durch das Messgerät 25, welches in diesem Fall die Speisespannung von beispielsweise 4V als die Messspannung direkt zur Verfügung stellt. Es ist mithin kein Zusatzadapter 27 erforderlich.

Fig. 7 erläutert nun das Prinzip der Widerstandsmessung, denn dort ist der Widerstand, der gemessen wird, gegen die Zeit nach Anlegen der Speisespannung, also Beginn der Widerstandsmessung, aufgetragen. Ersichtlich steigt der Widerstand gemäß der für ein keine Fehler aufweisende Systeme dargestellten Kurve 37 zunächst an, während sich der Zwischenkreiskondensator 9 auflädt. Sodann erreicht er langsam einen im Wesentlichen konstanten Wert. Es wird also für die Widerstandsmessung für eine bestimmte, ebenso im Rahmen einer Kalibrierung, Simulation und/oder Berechnung bestimmbare Aufladezeitspanne 38, die beispielsweise zwischen sieben und einundzwanzig Sekunden liegen kann, gewartet, und dann überprüft, ob der gemessene Widerstandswert in einem zweiten Sollbereich 39 liegt, der in Fig. 7 nicht gestrichelt angezeigt ist. Dieser ist wiederum aus Kalibrierungsmessungen, Simulationen und/oder Berechnungen leicht gewinnbar. Bemerkenswert ist im vorliegenden Fall die Aussagekraft von Widerständen in sonstigen Bereichen. Wird ein äußerst hoher Widerstand, beispielsweise im Bereich 40, gemessen, deutet dies auf einen Kabel-/Leitungsbruch oder eine defekte Sicherung 18 hin. Über den Bereich 41 werden beispielsweise Kurzschlüsse, insbesondere im Messgerät 25 oder dem Messadapter 21, oder aber im Inneren der Leistungselektronikbaueinheit 5, abgedeckt. Auch hier ist mithin eine über eine binäre Entscheidung hinausgehende Interpretation seitens der Auswerteeinrichtung 26 denkbar.

Während das Messgerät 25 auf Widerstandsmessungen eingestellt ist, ist es im zweiten Messabschnitt auch vorteilhaft, zur Vorbereitung weiterer, noch zu erläuternder Messungen im dritten Messabschnitt einen Widerstand zwischen dem Referenzpotential 19 und einem Schirmkontakt des Messadapters 21 zu messen. Nur wenn beide auf dem korrekten Potential liegen, sind später noch durchzuführende Messungen sinnvoll auswertbar. Dies ist aber wiederum optional.

Es sei an dieser Stelle noch angemerkt, dass die Sollbereiche 35, 39 auch, soweit sinnvoll möglich, für mehrere Fahrzeuge unterschiedlicher Spezifikationen bezüglich des Hochspannungssystems 1 bestimmt werden können, insbesondere für eine gesamte Flotte eines Herstellers.

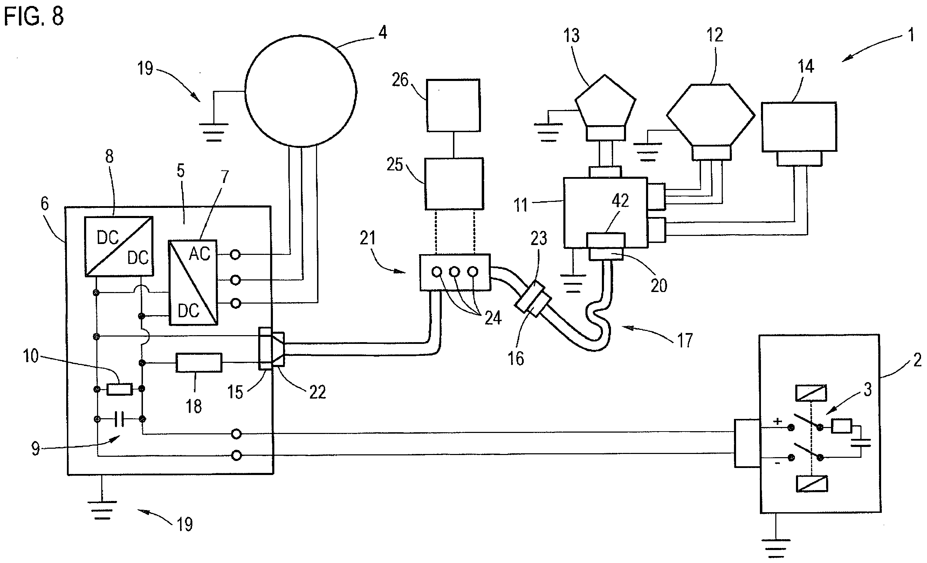

Den hauptsächlichen Messungen im zweiten Messabschnitt kann nun ein dritter Messabschnitt erfolgen, für den die Hochspannungsverbraucher wieder an die Leistungselektronikbaueinheit 5 angeschlossen werden, diesmal jedoch über den Messadapter 21. Dies ist in Fig. 8 beispielhaft für die erste Variante (Fig. 2) gezeigt, wonach dann der Stecker 16 des Kabels 17 in den Steckanschluss 23 des Messadapters 21 eingesteckt wird. In der zweiten Variante (Fig. 3) würde der Stecker 22 des Messadapters 21 an das Ladegerät 11, Zielanschluss 42, angeschlossen.

Dann lässt sich zunächst, indem wiederum die Spannung über die Hochspannungskontakte des Steckanschlusses 15 gemessen wird, die Spannungsfreiheit feststellen, in diesem Fall für das gesamte Hochspannungsnetz 1. Nachdem auch ein Messanschluss 24 für einen Schirmkontakt vorgesehen ist, lassen sich zudem möglicherweise vorliegende Spannungen zwischen dem Referenzpotential 19 und den Hochspannungskontakten des Steckanschlusses 15 feststellen, um weitere denkbare Fehlerfälle abzudecken.

Der dritte Messabschnitt ist, wie bereits erwähnt wurde, optional, nachdem das Wesentliche ist, festzustellen, ob die Leistungselektronikbaueinheit 5 spannungsfrei geschaltet ist, da die Steckverbindungen der Hochspannungsverbraucher üblicherweise und im vorliegenden Ausführungsbeispiel berührgeschützt ausgeführt sind.

Es sei noch angemerkt, dass selbstverständlich auch für den dritten Messabschnitt nochmals eine Überprüfung des Messgeräts 25 über die Referenzspannung der Niedrigspannungsbatterie erfolgen kann.

**Patentansprüche**

1. Verfahren zur Überprüfung der Spannungsfreiheit einer mit einer Hochspannungsbatterie (2) und einer Elektromaschine (4) verbundenen Leistungselektronikbaueinheit (5) in einem Hochspannungsnetz (1) eines Kraftfahrzeuges, das eine höhere Spannung als ein Niedrigspannungsnetz des Kraftfahrzeugs aufweist, wobei die Leistungselektronikbaueinheit (5) einen Zwischenkreiskondensator (9), einen passiven Entladewiderstand (10), einen Steckanschluss (15) für wenigstens einen Hochspannungsverbraucher und eine dem Steckanschluss (15) vorgeschaltete Sicherung (18) aufweist,
**dadurch gekennzeichnet,**
**dass** nach einer Trennung der Hochspannungsbatterie (2) von dem Hochspannungsnetz (1) und bei aus dem Steckanschluss (15) oder einem Zielanschluss (42) des in dem Steckanschluss (15) eingesteckten Kabels (17) gezogenem Stecker (16, 20) über den Hochspannungskontakten des Steckanschlusses (15) eine Speisespannung angelegt und der Spannungsverlauf über die Hochspannungskontakte mit einem Messgerät (25) und/oder nach einer definierten Aufladezeitspanne (38) des Zwischenkreiskondensators (9) der Widerstand über die Hochspannungskontakte mit dem Messgerät (25) vermessen wird, wobei eine Spannungsfreiheit bei einem in einem ersten Sollbereich (35) liegenden Spannungsverlauf bzw. einem in einem zweiten Sollbereich (39) liegenden Widerstand festgestellt wird.

2. Verfahren nach Anspruch 1,
**dadurch gekennzeichnet,**
**dass** vor der Spannungsverlaufs- und/oder Widerstandsmessung eine Spannungsmessung über die Hochspannungskontakte des Steckanschlusses (15) durchgeführt wird.

3. Verfahren nach Anspruch 1 oder 2,
**dadurch gekennzeichnet,**
**dass** nach der Spannungsverlaufs- und/oder Widerstandsmessung bei festgestellter Spannungsfreiheit bei wenigstens einem wieder angeschlossenen Hochspannungsverbraucher eine Spannungsmessung über die Hochspannungskontakte des Steckanschlusses (15) durchgeführt wird.

4. Verfahren nach Anspruch 3,
**dadurch gekennzeichnet,**
**dass** zusätzlich eine Spannungsmessung zwischen jeweils einem Hochspannungskontakt des Steckanschlusses (15) und einem Schirmkontakt zu einem Referenzpotential (19), insbesondere Masse, durchgeführt wird.

5. Verfahren nach einem der Ansprüche 2 bis 4,
**dadurch gekennzeichnet,**
**dass** bei jeder Spannungsmessung zunächst die Funktionsfähigkeit des Messgeräts (25) durch Vermessung einer Referenzspannung überprüft wird, insbesondere der Spannung einer Niedrigspannungsbatterie des Niedrigspannungsnetzes.

6. Verfahren nach einem der vorangehenden Ansprüche,
**dadurch gekennzeichnet,**
**dass** nach Ziehen des Steckers (16, 20) zu dem wenigstens einen Hochspannungsverbraucher aus dem Steckanschluss (15) oder Zielanschluss (42) ein Messadapter (21) an den Steckanschluss (15) oder das in dem Steckanschluss (15) eingesteckte Kabel (17) angeschlossen wird, wobei das Messgerät (25) und die Speisespannung an Messanschlüsse (24) des Messadapters (21) angeschlossen werden.

7. Verfahren nach Anspruch 6,
**dadurch gekennzeichnet,**
**dass** der Messadapter (21) für jeden Hochspannungs-Messanschluss (24) je einen Berührschutzwiderstand (36) aufweist, der bei der Ermittlung des ersten und/oder zweiten Sollbereichs (35, 39) insbesondere für den Widerstand berücksichtigt wird.

8. Verfahren nach einem der vorangehenden Ansprüche,
**dadurch gekennzeichnet,**
**dass** die Auswertung des Spannungsverlaufs und/oder des Widerstands durch eine dem Messgerät (25) nachgeschaltete Auswerteeinrichtung (26) erfolgt, wobei insbesondere das Messgerät (25) und/oder die Auswerteeinrichtung (26) Teil eines Werkstatt-Testers sind.

9. Verfahren nach einem der vorangehenden Ansprüche,
**dadurch gekennzeichnet,**
**dass** der erste und/oder zweite Sollbereich (35, 39) aus Ergebnissen einer Kalibrierungsmessung und/oder aus einer Simulation und/oder aus theoretischen Berechnungen ermittelt wird oder werden.

10. Verfahren nach einem der vorangehenden Ansprüche,
**dadurch gekennzeichnet,**
**dass** als der erste und/oder zweite Sollbereich (35, 39) für wenigstens zwei unterschiedliche Spezifikationen aufweisende Kraftfahrzeuge gültige Sollbereiche verwendet werden.

11. Verfahren nach einem der vorangehenden Ansprüche,
**dadurch gekennzeichnet,**
**dass** die Speisespannung kleiner als 30 Volt ist.

12. Verfahren nach einem der vorangehenden Ansprüche,
**dadurch gekennzeichnet,**
**dass** bei einer Messung des Spannungsverlaufs ein Netzteil (28) für die Speisespannung verwendet wird.

13. Verfahren nach Anspruch 12,
**dadurch gekennzeichnet,**
**dass** zum Schutz des Netzteils eine Schutzdiode (29) verwendet wird.

**Claims**

1. Method for checking the absence of voltage of a power electronics unit (5) connected to a high-voltage battery (2) and an electric machine (4) in a high-voltage supply system (1) of a motor vehicle, said high-voltage supply system having a higher voltage than a low-voltage supply system of the motor vehicle, wherein the power electronics unit (5) has an intermediate circuit capacitor (9), a passive discharge resistor (10), a plug connection (15) for at least one high voltage consumer and a fuse (18) connected upstream of the plug connection (15),
**characterised in that**
after a separation of the high-voltage battery (2) from the high-voltage supply system (1) and when a plug (16, 20) is pulled out of the plug connection (15) or out of a target connection (42) of the cable (17) inserted into the plug connection (15), a supply voltage is created across the high-voltage contacts of the plug connection (15) and the voltage curve across the high-voltage contacts is measured using a measuring instrument (25) and/or the resistance across the high-voltage contacts is measured using the measuring instrument (25) after a defined charging period (38) of the intermediate circuit capacitor (9), wherein an absence of voltage is specified for a voltage curve in a first target region (35) or a resistance in a second target region (39).

2. Method according to claim 1,
**characterised in that**,
before the voltage curve measurement and/or resistance measurement, a voltage measurement is performed across the high-voltage contacts of the plug connection (15).

3. Method according to claim 1 or 2,
**characterised in that**,
after the voltage curve measurement and/or resistance measurement, in the case where the absence of voltage is determined, a voltage measurement across the high-voltage contacts of the plug connection (15) is performed for at least one reconnected high-voltage consumer.

4. Method according to claim 3,
**characterised in that**,
additionally, a voltage measurement is performed between both a high-voltage contact of the plug connection (15) and a shield contact, with respect to a reference potential (19), in particular an earth.

5. Method according to any one of claims 2 to 4,
**characterised in that**,
for each voltage measurement, firstly the functionality of the measuring instrument (25) is checked by measuring a reference voltage, in particular the voltage of a low voltage battery of the low voltage supply system.

6. Method according to any one of the preceding claims,
**characterised in that**
after pulling the plug (16, 20) for the at least one high-voltage consumer out of the plug connection (15) or target connection (42), a measuring adapter (21) is connected to the plug connection (15) or to the cable (17) inserted into the plug connection (15), wherein the measuring instrument (25) and the supply voltage are connected to measurement connections (24) of the measuring adapter (21).

**7.** Method according to claim 6,
**characterised in that**,
the measuring adapter (21) for each high-voltage measurement connection (24) has a contact protection resistor (36) which is considered during the determination of the first and/or second target region (35, 39), in particular for the resistance.

**8.** Method according to any one of the preceding claims,
**characterised in that**
the evaluation of the voltage curve and/or the resistance occurs using an evaluation device (26) connected downstream of the measuring instrument (25), wherein in particular the measuring instrument (25) and/or the evaluation device (26) are part of a workshop tester.

**9.** Method according to any one of the preceding claims,
**characterised in that**
the first and/or second target region (35, 39) is or are determined from results of a calibration measurement and/or from a simulation and/or from theoretical calculations.

**10.** Method according to any one of the preceding claims,
**characterised in that**
target regions which are valid for at least two motor vehicles having different specifications are used as the first and/or second target region (35, 39).

**11.** Method according to any one of the preceding claims,
**characterised in that**
the supply voltage is less than 30 volts.

**12.** Method according to any one of the preceding claims,
**characterised in that**,
in the case of a measurement of the voltage curve, a power adapter (28) is used for the supply voltage.

**13.** Method according to claim 12,
**characterised in that**
a protective diode (29) is used to protect the power adapter.

**Revendications**

**1.** Procédé servant à surveiller l'absence de tension au niveau d'un module électronique de puissance (5) relié à une batterie à haute tension (2) et à un moteur électrique (4) dans un réseau à haute tension (1) d'un véhicule automobile, lequel réseau à haute tension présente une tension supérieure à celle d'un réseau à basse tension du véhicule automobile, le module électronique de puissance (5) présentant un condensateur de circuit intermédiaire (9), une résistance de décharge (10) passive, une fiche de connexion (15) pour au moins un consommateur à haute tension et un fusible (18) branché en amont de la fiche de connexion (15),
**caractérisé en ce**
**que**, après que la batterie à haute tension (2) a été séparée du réseau à haute tension (1) et lorsqu'un connecteur (16, 20) est tiré hors de la fiche de connexion (15) ou d'une fiche cible (42) du câble (17) enfiché dans la fiche de connexion (15), une tension d'alimentation est appliquée sur les contacts à haute tension de la fiche de connexion (15) et la courbe de tension sur les contacts à haute tension est mesurée avec un appareil de mesure (25) et/ou, après un temps de charge (38) défini du condensateur de circuit intermédiaire (9), la résistance sur les contacts à haute tension est mesurée avec l'appareil de mesure (25), une absence de tension étant constatée dans le cas d'une courbe de tension située dans une première plage de consigne (35) ou dans le cas d'une résistance située dans une deuxième plage de consigne (39).

**2.** Procédé selon la revendication 1,
**caractérisé en ce**
**que**, avant la mesure de courbe de tension et/ou de résistance, on effectue une mesure de tension sur les contacts à haute tension de la fiche de connexion (15).

**3.** Procédé selon la revendication 1 ou 2,
**caractérisé en ce**
**que**, après la mesure de courbe de tension et/ou de résistance, dans le cas d'une absence de tension constatée pour au moins un consommateur à haute tension à nouveau raccordé, on effectue une mesure de tension sur les contacts à haute tension de la fiche de connexion (15).

**4.** Procédé selon la revendication 3,
**caractérisé en ce**
**que** l'on effectue en supplément une mesure de tension entre respectivement un contact à haute tension de la fiche de connexion (15) et un contact écran avec un potentiel de référence (19), en particulier la masse.

**5.** Procédé selon l'une quelconque des revendications 2 à 4,
**caractérisé en ce**
**que**, à chaque mesure de tension, on surveille d'abord le bon fonctionnement de l'appareil de mesure (25) en mesurant une tension de référence, en particulier la tension d'une batterie à basse tension du réseau à basse tension.

**6.** Procédé selon l'une quelconque des revendications précédentes, **caractérisé en ce que**, après le retrait du connecteur (16, 20) menant à l'au moins un consommateur à haute tension hors de la fiche de connexion (15) ou d'une fiche cible (42), on raccorde un adaptateur de mesure (21) à la fiche de connexion (15) ou au câble (17) enfiché dans la fiche de connexion (15), l'appareil de mesure (25) et la tension d'alimentation étant raccordés à des bornes de mesure (24) de l'adaptateur de mesure (21).

**7.** Procédé selon la revendication 6, **caractérisé en ce que** l'adaptateur de mesure (21) présente pour chaque borne de mesure de haute tension (24) respectivement une résistance (36) de protection contre les contacts, qui est prise en compte lors de la détermination de la première et/ou de la deuxième plage de consigne (35, 39) en particulier pour la résistance.

**8.** Procédé selon l'une quelconque des revendications précédentes, **caractérisé en ce que** l'évaluation de la courbe de tension et/ou de la résistance s'effectue par un dispositif d'évaluation (26) branché en aval de l'appareil de mesure (25), en particulier l'appareil de mesure (25) et/ou le dispositif d'évaluation (26) faisant partie d'un dispositif de test en atelier.

**9.** Procédé selon l'une quelconque des revendications précédentes, **caractérisé en ce que** la première et/ou la deuxième plage de consigne (35, 39) sont déterminées à partir de résultats d'une mesure de calibrage et/ou d'une simulation et/ou de calculs théoriques.

**10.** Procédé selon l'une quelconque des revendications précédentes, **caractérisé en ce que**, comme première et/ou deuxième plage de consigne (35, 39), on utilise des plages de consigne valables pour des véhicules automobiles présentant au moins deux spécifications différentes.

**11.** Procédé selon l'une quelconque des revendications précédentes, **caractérisé en ce que** la tension d'alimentation est inférieure à 30 V.

**12.** Procédé selon l'une quelconque des revendications précédentes, **caractérisé en ce que**, lors d'une mesure de la courbe de tension, on utilise un bloc d'alimentation (28) pour la tension d'alimentation.

**13.** Procédé selon la revendication 12, **caractérisé en ce que**, pour la protection du bloc d'alimentation, on utilise une diode de protection (29).

FIG. 1

EP 3 007 963 B1

FIG. 2

EP 3 007 963 B1

FIG. 3

EP 3 007 963 B1

FIG. 4

FIG. 5

17

FIG. 6

FIG. 7

FIG. 8

EP 3 007 963 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010056235 A1
- DE 102010012154 A1
- DE 102012000598 A1